# EUROPEAN PATENT SPECIFICATION

(11) **EP 3 878 659 B1**
(45) Date of publication and mention of the grant of the patent: **19.07.2023**
(21) Application number: 20161874.1
(22) Date of filing: 09.03.2020
(51) Int. Cl.: B41N 3/00, C23C 14/06, C23C 14/02, C23C 28/00, C22C 29/00, B41N 1/00, B41M 1/10, C23C 30/00, C22C 32/00, C23C 4/06, C23C 4/12, B41N 1/20, B41N 1/06, C23C 4/067, C23C 4/137

(54) **COATED INTAGLIO PRINTING PLATE**
BESCHICHTETE TIEFDRUCKPLATTE
PLAQUE REVÊTUE POUR L'IMPRESSION EN CREUX

(43) Date of publication of application: 15.09.2021
(73) Proprietor: Emea Inor Eood, 4000 Plovdiv (BG)
(72) Inventor: Waidelich, Romain, 70197 Stuttgart (DE); Andritschky, Martin, 4805-005 Balazar (PT)
(74) Representative: Hoeger, Stellrecht & Partner Patentanwälte mbB

(56) References cited:
- EP-A1- 0 289 173
- EP-A1- 2 514 594
- WO-A1-2013/190293
- VITICOLI M ET AL: "deposizione di rivestimenti PVD su lastre di nichel elettroformate: una soluzione innovativa per la stampacalcografica delle banconote", AIFM AIFM - GALVANOTECNICA, 1 March 2011 (2011-03-01), XP055524744,
- INOUE SHOZO ET AL: "Preparation of compositionally gradient Ti-TiN films by r.f. reactive sputtering", THIN SOLID FILMS, vol. 261, no. 1, 1 June 1995 (1995-06-01), pages 115-119, XP085395561, ISSN: 0040-6090, DOI: 10.1016/S0040-6090(95)06527-X

## Description

### FIELD OF THE INVENTION

The invention relates to an intaglio printing plate, comprising a metallic substrate and a protective coating deposited on the substrate by physical vapor deposition.

For numerous printing operations, printing of banknotes and security documents being part of it, the printing process is based on direct transfer of the ink from a printing plate. For intaglio printing, the image is incised into the printing plate. Engraving, chemical etching, laser etching or similar techniques can do the incisions. The metallic printing plate is commonly made of copper, zinc, nickel, brass or steel plates.

During the printing process, the incisions are filled with ink. Subsequently, the printing plate is pressed against the paper to be printed on. During the contact, the printing plate is subjected to mechanical stress and wear by some of the ink components and the paper. Commonly, a chromium layer, deposited by galvanic techniques, protects the printing plate. The chromium layer, based on hexavalent Cr being environmentally harmful and therefore undesirable, is of moderate hardness and abrasion resistance. One major limitation of the lifetime of the printing plate is the degradation of the protective chromium layer.

### BACKGROUND ART

The metallic intaglio printing plate is coated either as a flat plate, as suggested in patent EP 3 103 650 B1, or, since several decades, already in its final shape, being a section of a cylinder. A very specific configuration of the latter is revealed in patent application EP 2 832 555 A1. For security printing, the printing plate is made of a relatively soft material like nickel, brass or similar. Traditionally, the protective coating consists of a 5 to 10 µm thick galvanic chromium layer. This electroplated Cr-layer shows a Vickers hardness close to 1060 HV.

To protect a surface against wear and corrosion, metallic and more frequently hard ceramic PVD coatings are used for tool surfaces in numerous applications. Most tools, such as cutting tools, punches, dies are made of hard substrates (surface hardness frequently around 620 HV). To increase coating lifetime, modern tool coatings may consist of multilayer structures or, less frequently, of mixtures of soft and hard materials (see M.-S. Leu et al.: "Microstructure and physical properties of arc ion plated TiAIN/Cu thin film", Surface and Coatings Technology 201 (2006) 3982-3986).

In the case of intaglio printing plates, and in contrast to the mentioned tooling applications, the substrate is relatively soft (typically 200 to 500 HV), and hard coatings tend to fail during printing applications by cracking. During application, the coated printing plates are subjected to a high linear contact pressure in the order of 100 MPa in combination with the abrasive action of some ink components and the paper to be printed on.

Nevertheless, as revealed in patent applications EP 0 446 762 A2 and EP 2 236 649 A1, hard coatings have been used to increase printing plate lifetime. EP 0 446 762 A2 describes the coating of an intaglio printing plate with a bulk ceramic hard coating. EP 2 236 649 A1 describes the coating of a printing plate with a hard coating with the introduction of prefabricated nanoparticles, with not defined material, from a separate source. As in EP 0 446 762 A2, the composition of the coating is homogenous throughout the thickness.

Several scientific papers show that best wear behaviour, which is commonly related to high hardness, is not the best solution at rolling contact fatigue in connection with a ductile substrate (see Diego A. Colombo et al.: "Mechanical and tribological behaviour of Ti/TiN and TiAI/TiAIN coated austempered ductile iron", Thin Solid Films 647 (2018) 19-25).

Physical vapour deposition (PVD) is a preferred coating method because it allows the coating of complex surfaces homogenously, following exactly the existing surface relief. Independently on the incision method mentioned above, PVD coatings can be used as protective coating. Nevertheless, the combination of high contact pressure and soft substrate material and hard coating requires a strict control of mechanical stress in the coating and the development of a tough coating. Especially at the edges of the grooves of the intaglio printing plate, three-dimensional stresses exist. Stress control, avoiding intrinsic stress, thermal stress and mechanical bending stress in the coating is of uttermost importance in PVD coatings (see V. Teixeira et al.: "Mechanical integrity in PVD coatings due to the presence of residual stresses", Thin Solid Films 392 (2001) 276-281).

EP 2 514 594 A1 discloses an intaglio printing plate for the production of bank notes and like printed securities, which intaglio printing plate comprises an engraved polymer layer and wherein a surface of the engraved polymer layer is covered by one or more coatings including an outer coating made of a wear-resistant material.

WO 2013/190293 A1 discloses plates for use in printing processes and describes the coating of at least one of the surfaces of the same to reduce the wear and improve the clarity of the etched image on said surface and thereby improve the printing obtained.

M. Viticolli et al. in AIFM-Galvanotecnica 3-2011, page 147, describe the deposition of PVD coatings on electroformed nickel plates for use in bank notes intaglio printing.

It is an object of the present invention to overcome the above-mentioned drawbacks of the prior art, and to provide an intaglio printing plate which has an increased lifetime and which allows for an improved quality of printing.

### SUMMARY OF THE INVENTION

This object is achieved with the intaglio printing plate according to claim 1. Preferred embodiments are recited in the dependent claims.

The gist of the present invention is a replacement of an electrodeposited chromium layer by a functionally graded material (FGM), which is environmentally harmless and deposited by vacuum technologies, more specifically by PVD. Besides the obvious environmental issues connected to electroplated Cr, the main advantage of the invention over prior art is to enhance significantly the lifetime of the intaglio printing plate. The application of the invention is preferably found in areas defined by high volume precision printing, such as during the production of banknotes.

It has been found by the inventors that the demanding conditions in the printing plate application require a non-homogenous mechanical property distribution within the coating. At the substrate/coating interface, the coating hardness should be similar to the substrate hardness to avoid local stress spikes. The coating surface, being in contact with the ambient, should be hard and most wear resistant. These conditions can be met, according to the invention, by the creation of an FGM, as for example shown in patent US 6,087,022 for bulk materials.

It is known to a person skilled in the art of PVD technology to grade transitions from one bulk material to a different bulk material, e.g. a coating consisting of a metallic substrate with Cr adhesion layer and a ceramic top layer. In such a case, the transition from the metallic adhesion layer to the nitride ceramic layer is graded by increasing gradually the nitrogen content in the transition (see E. Uribe et al.: "Evolution of PVD Al oxide coatings in carburizing atmospheres at high temperature", Surface and Coatings Technology 284 (2015) 2-8; and G.W. Critchlow et al: "Adhesion of wear resistant hard coatings to steel substrates", Tribology International 30 (1997) 499-506).

It is also known in the art to tailor the material properties of a vacuum deposited material by introducing a multilayer structure of two different materials (see X. Xu et al.: "Tribological properties of nanostructured TiAlN/W2N multilayer coating produced by PVD", Wear 430-431 (2019) 67-75; and M. Andritschky et al.: "Multilayered decorative a-C:H/CrC coating on stainless steel", Surface and Coatings Technology 203 (2009) 952-956). Adequate mixture of a hard ceramic coating with a metallic phase in the form of inclusion of nanoparticles or in the form of nano-layers creates a tough material, as shown in patent application US 2010/0101368 A1 for a bulk functionally graded cemented tungsten carbide (WC-Co).

The present invention tailors the material properties of the PVD coating by changing adequately the mixing rate throughout the coating thickness. As such, a lower hardness at the interface and higher hardness at the surface is achieved. The material properties are similar to the substrate at the substrate/ coating interface (i.e. at the substrate-side of the coating), thus avoiding mechanical stress peaks under load. The material properties of the coating corresponding to high wear and tear resistance at the coating surface (i.e. the opposite side of the coating) functionalize the coating adequately. Between these two extremes, the mechanical properties of the coating change gradually.

One major failure mode of ceramic coatings is failure due to crack propagation through the coating thickness and reflection of the crack at the metallic interface towards the surface (coating pitting). In FGMs, the soft and ductile material component stops the crack propagation and is responsible for the coating toughness.

In summary, the FGM provides for a tough, crack-stopping phase at the substrate/coating interface, and for a hard, abrasion resistant coating at the surface of the coating (which is contact with paper). Additionally, the FGM allows a rigorous control of the intrinsic coating stress, which is paramount for good adhesion and resistance against external mechanical stresses.

In the inventive intaglio printing plate, the ceramic phase of the FGM is preferably selected from one or more metal nitrides and/or metal carbides of the elements Al, Si, Y, La, Ti, Zr, V, Nb, Ta, Cr, Mo and Co. The Vickers hardness of the ceramic phase is preferably between 2200 HV 0.005 and 3200 HV 0.005.

The metallic phase is preferably selected from one or more of the metallic elements Co, Ni, Cu, Ag, Au and Zn. The Vickers hardness of the metallic phase is preferably between 300 HV 0.005 and 600 HV 0.005.

Preferably, the percentage of the metallic phase is between 15 and 70% at the substrate-side of the coating and between 0 and 15% at the opposite side of the coating. The average percentage of the metallic phase within the functionally graded material is preferably between 5 and 50%.

The variation of the percentage of the metallic phase between the two sides of the coating can be linear, parabolic, exponential, logarithmic or a combination thereof.

In the first alternative embodiment of the inventive intaglio printing plate, the ceramic phase constitutes a matrix phase of the functionally graded material and the metallic phase constitutes nanoparticles distributed therein, the variation of the percentage of the metallic phase resulting from a varying concentration of the nanoparticles.

In the second alternative embodiment of the invention, both the ceramic phase and the metallic phase constitute alternating layers of the functionally graded material, the variation of the percentage of the metallic phase resulting from varying thicknesses of the layers. The thickness of the individual layers is between 1 and 20 nm.

The total thickness of the coating of the inventive printing plate is preferably between 1.5 and 5 µm.

According to the invention, the coating is deposited either directly onto the substrate, or onto an intervening adhesion layer, preferably a metallic adhesion layer. The thickness of this adhesion layer is preferably between 50 and 200 nm. The present invention also pertains to the use of the inventive intaglio printing plate in an intaglio printing process.

### BRIEF DESCRIPTION OF THE DRAWINGS

The invention is further explained by way of the following exemplary embodiments with reference to the drawings, wherein
- FIG. 1: shows a schematic representation of an embodiment of the invention with an FGM based on nanoparticles; and
- FIG.2: shows a schematic representation of an embodiment of the invention with an FGM based on nano-layers.

### DETAILED DESCRIPTION OF THE INVENTION

The embodiments of the invention described below are based on (1) a substrate, (2) a hard coating phase and (3) a soft coating phase. A skilled person in the area of coatings will immediately recognize that other combinations of these ingredients are possible. Therefore, the invention is not limited to the three combinations described below, but includes all possible combinations which can be obtained from the claims.

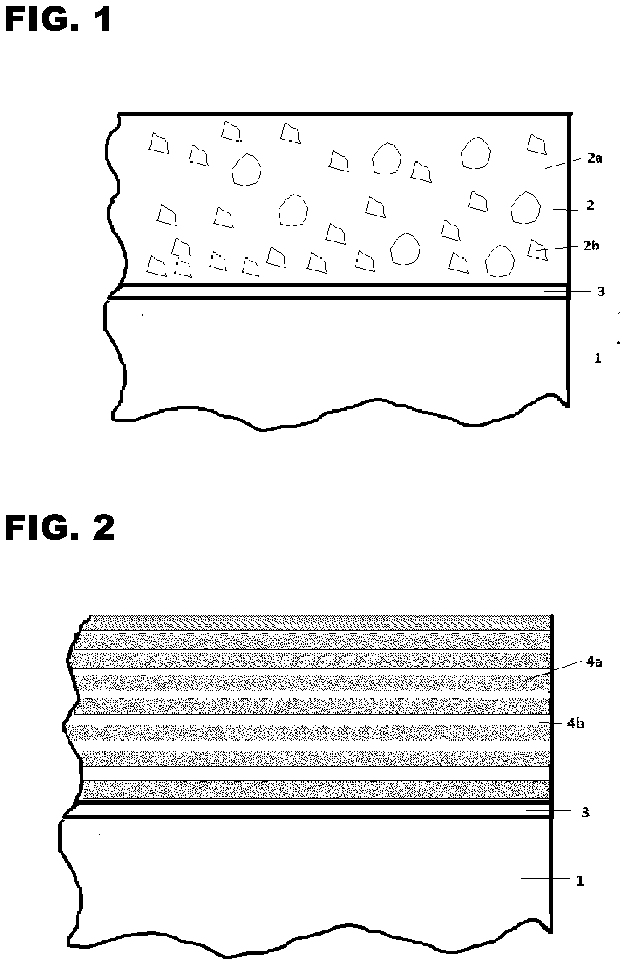

Chromium deposited by PVD technology is generally environmentally harmless and therefore belongs to the materials for the preferred embodiments. In any of the embodiments described below, the hard ceramic material and the soft metallic material are deposited simultaneously from separate sources, forming either a matrix with inclusions or a multi-layered structure as depicted in Figures 1 and 2, respectively:
Figure 1 schematically depicts an inventive intaglio printing plate with a coating 2 on a metallic substrate 1. The coating 2 consists of an FGM comprising a ceramic matrix phase 2a and metallic phase 2b in the form of nanoparticles. The percentage of the nanoparticles in the coating volume decreases from the substrate/coating interface towards the coating surface.
Figure 2 schematically depicts an inventive intaglio printing plate in which the FGM coating consists of ceramic layers 4a with similar thickness as the ceramic phase, and of metallic nano-layers 4b as the metallic phase. The thickness of the metallic layers decreases towards the coating surface.

Any person skilled in the art will recognize that an adequate substrate movement can achieve the distinction between these two forms of incorporation of the soft material during the deposition process. The graduation of the coating throughout the thickness is achieved by a gradual variation of either the deposition rate of the soft phase or the deposition rate of the hard phase throughout the coating process.

A person skilled in the art will also recognize that it is the state of the art to plasma clean and activate the substrate surface prior to the coating deposition. Additionally, a thin (e.g. 50 to 200 nm) pure metallic layer can be deposited as a so-called adhesion layer 3, as in most applications of hard and wear resistant coatings, to enhance the adherence of the coating 2 on the substrate 1.

A first exemplary embodiment of the invention is based on a nickel substrate, coated while being curved in its final geometry. The coating consists of a combination of a hard nitride coating which serves as a hard matrix, and a softer metallic nickel phase. The nitride coating is based on a metallic element of the group Al, Si, Ti, Zr, V, Nb, Ta, Cr, Mo and Co deposited by PVD technology in a reactive mode, nitrogen being the reactive element out of the gas phase. The nitride matrix is deposited preferably with a hardness of 2200 HV 0.005 to 2500 HV 0.005, and the Nickel inclusions (nanoparticles) with a hardness of about 300 HV 0.005 to 600 HV 0.005. An additional advantage of this FGM coating is its very good adhesion on the substrate, due to the chemical affinity of nickel present in the coating to the nickel substrate.

In the second exemplary embodiment, a copper substrate, already bent to its final curvature with a radius of about 300 mm, is coated. The coating of the bent substrate allows to reduce the tensile stress in the coating, as opposed to bending the flat substrate after coating to its cylindrical shape, necessary for the printing application. The coating is 2 to 4 µm thick and consists of a mixed nitride matrix, which can be deposited by PVD technology with a hardness between 2800 HV 0.005 and 3200 HV 0.005. The mixed nitride is based on two or more elements of the group Al, Si, Y, La, Ti, Zr, V, Nb, Cr, Mo and Co. The soft phase consists of copper with a percentage of 40 to 70% at the interface and a percentage less than 20% at the surface. The coating is deposited in a reactive PVD process with nitrogen being the reactive element in the gas phase. The nitrogen pressure during deposition is low, reducing the formation of Cu-N compounds. The deposition rates are chosen to avoid excessive substrate heating, maintaining the substrate temperature below 150 °C, thus avoiding thermal coating stresses. Again, an additional advantage of the FGM coating is its very good adhesion on the substrate, due to the chemical affinity of brass to Cu.

A third exemplary embodiment is based on a stainless steel substrate, again coated while being curved in its final geometry. The coating consists of a combination of a hard metal carbide matrix and a softer metallic nickel phase. One or two metal elements of the carbide are chosen from the group Al, Si, Y, La, Ti, Zr, V, Nb, Cr, Mo and Co. The carbide is deposited, preferably, with a hardness of about 2500 HV 0.005 to 3200 HV 0.005, and the nickel with a hardness of about 300 HV 0.005 to 600 HV 0.005. Carbides generally show a lower friction coefficient than most other materials to paper and therefore, even at a lower hardness, a low abrasion rate. Again, one additional advantage of the FGM coating is its very good adhesion on the substrate, due to the chemical affinity of nickel present in the coating to the nickel containing substrate.

## Claims

1. An intaglio printing plate, comprising a metallic substrate and a protective coating deposited on the substrate by physical vapor deposition, wherein the protective coating consists of a functionally graded material comprising a ceramic phase and a metallic phase, wherein the ceramic phase is harder than the metallic phase, Charaterized in that the percentage of the metallic phase within the functionally graded material increases in a direction towards the substrate, and
(i) wherein the ceramic phase constitutes a matrix phase of the functionally graded material and the metallic phase constitutes nanoparticles distributed therein, the variation of the percentage of the metallic phase resulting from a varying concentration of the nanoparticles; or
(ii) wherein both the ceramic phase and the metallic phase constitute a plurality of alternating layers of the functionally graded material, the variation of the percentage of the metallic phase resulting from varying thicknesses of the layers, wherein the thickness of the individual layers is between 1 and 20 nm.

2. The intaglio printing plate of claim 1, wherein ceramic phase is selected from one or more metal nitrides and/or metal carbides of the elements Al, Si, Y, La, Ti, Zr, V, Nb, Ta, Cr, Mo and Co.

3. The intaglio printing plate of claim 1 or 2, wherein the Vickers hardness of the ceramic phase is between 2200 HV 0.005 and 3200 HV 0.005.

4. The intaglio printing plate of any one of the preceding claims, wherein the metallic phase is selected from one or more of the metallic elements Co, Ni, Cu, Ag, Au and Zn.

5. The intaglio printing plate of any one of the preceding claims, wherein the Vickers hardness of the metallic phase is between 300 HV 0.005 and 600 HV 0.005.

6. The intaglio printing plate of any one of the preceding claims, wherein the percentage of the metallic phase is between 15 and 70% at the substrate-side of the coating and between 0 and 15% at the opposite side of the coating.

7. The intaglio printing plate of any one of the preceding claims, wherein the average percentage of the metallic phase within the functionally graded material is between 5 and 50%.

8. The intaglio printing plate of any one of the preceding claims, wherein the variation of the percentage of the metallic phase between the two sides of the coating is linear, parabolic, exponential, logarithmic or a combination thereof.

9. The intaglio printing plate of any one of the preceding claims, wherein the total thickness of the coating is between 1.5 and 5 µm.

10. The intaglio printing plate of any one of the preceding claims, wherein the coating is deposited directly onto the substrate, or onto an intervening adhesion layer, preferably a metallic adhesion layer.

11. Use of the intaglio printing plate of any one of the preceding claims in an intaglio printing process.

## Patentansprüche

1. Tiefdruckplatte, umfassend ein metallisches Substrat und eine Schutzschicht, die auf das Substrat durch physikalische Gasphasenabscheidung aufgebracht ist, wobei die Schutzschicht aus einem funktional gradierten Material besteht, welches eine keramische Phase und eine metallische Phase umfasst, wobei die keramische Phase härter ist als die metallische Phase,
**dadurch gekennzeichnet, dass** der Anteil der metallischen Phase innerhalb des funktional gradierten Materials in Richtung des Substrates zunimmt, und
(i) wobei die keramische Phase eine Matrixphase des funktional gradierten Materials bildet und die metallische Phase darin verteilte Nanopartikel bildet, wobei die Variation des Anteils der metallischen Phase aus einer variierenden Konzentration der Nanopartikel resultiert; oder
(ii) wobei sowohl die keramische Phase als auch die metallische Phase eine Mehrzahl von abwechselnden Lagen des funktional gradierten Materials bilden, wobei die Variation des Anteils der metallischen Phase aus variierenden Dicken der Lagen resultiert, und wobei die Dicke der einzelnen Lagen zwischen 1 und 20 nm beträgt.

2. Tiefdruckplatte nach Anspruch 1, wobei die keramische Phase ausgewählt ist aus einem oder mehreren Metallnitriden und/oder Metallkarbiden der Elemente Al, Si, Y, La, Ti, Zr, V, Nb, Ta, Cr, Mo und Co.

3. Tiefdruckplatte nach Anspruch 1 oder 2, wobei die Vickers-Härte der keramischen Phase zwischen 2.200 HV 0,005 und 3.200 HV 0,005 beträgt.

4. Tiefdruckplatte nach einem der vorhergehenden Ansprüche, wobei die metallische Phase ausgewählt ist aus einem oder mehreren der metallischen Elemente Co, Ni, Cu, Ag, Au und Zn.

5. Tiefdruckplatte nach einem der vorhergehenden Ansprüche, wobei die Vickers-Härte der metallischen Phase zwischen 300 HV 0,005 und 600 HV 0,005 beträgt.

6. Tiefdruckplatte nach einem der vorhergehenden Ansprüche, wobei der Anteil der metallischen Phase an der Substrat-Seite der Beschichtung zwischen 15 und 70 % beträgt und an der gegenüberliegenden Seite der Beschichtung zwischen 0 und 15 % beträgt.

7. Tiefdruckplatte nach einem der vorhergehenden Ansprüche, wobei der mittlere Anteil der metallischen Phase innerhalb des funktionalgradierten Materials zwischen 5 und 50 % beträgt.

8. Tiefdruckplatte nach einem der vorhergehenden Ansprüche, wobei die Variation des Anteils der metallischen Phase zwischen den zwei Seiten der Beschichtung linear, parabolisch, exponentiell, logarithmisch oder eine Kombination hiervon ist.

9. Tiefdruckplatte nach einem der vorhergehenden Ansprüche, wobei die gesamte Dicke der Beschichtung zwischen 1,5 und 5 µm beträgt.

10. Tiefdruckplatte nach einem der vorhergehenden Ansprüche, wobei die Beschichtung direkt auf das Substrat aufgebracht ist, oder auf eine dazwischenliegende Adhäsionsschicht, bevorzugt eine metallische Adhäsionsschicht.

11. Verwendung der Tiefdruckplatte nach einem der vorhergehenden Ansprüche in einem Tiefdruckverfahren.

## Revendications

1. Plaque pour impression en creux, comprenant un substrat métallique et un revêtement protecteur déposé sur le substrat par dépôt physique en phase vapeur,
dans laquelle le revêtement protecteur consiste en un matériau à gradient de fonctionnalité comprenant une phase céramique et une phase métallique,
dans laquelle la phase céramique est plus dure que la phase métallique,
**caractérisée en ce que** le pourcentage de la phase métallique dans le matériau à gradient de fonctionnalité augmente dans une direction vers le substrat, et
(i) dans laquelle la phase céramique constitue une phase de matrice du matériau à gradient de fonctionnalité et la phase métallique constitue des nanoparticules réparties à l'intérieur de celle-ci, la variation du pourcentage de la phase métallique résultant d'une concentration variable des nanoparticules ; ou
(ii) dans laquelle à la fois la phase céramique et la phase métallique constituent une pluralité de couches alternées du matériau à gradient de fonctionnalité, la variation du pourcentage de la phase métallique résultant des épaisseurs variables des couches, dans laquelle l'épaisseur des couches individuelles est entre 1 et 20 nm.

2. Plaque pour impression en creux selon la revendication 1, dans laquelle la phase céramique est sélectionnée parmi un ou plusieurs nitrures métalliques et/ou carbures métalliques des éléments Al, Si, Y, La, Ti, Zr, V, Nb, Ta, Cr, Mo et Co.

3. Plaque pour impression en creux selon la revendication 1 ou 2, dans laquelle la dureté Vickers de la phase céramique est entre 2200 HV 0,005 et 3200 HV 0,005.

4. Plaque pour impression en creux selon l'une quelconque des revendications précédentes, dans laquelle la phase métallique est sélectionnée parmi un ou plusieurs des éléments métalliques Co, Ni, Cu, Ag, Au et Zn.

5. Plaque pour impression en creux selon l'une quelconque des revendications précédentes, dans laquelle la dureté Vickers de la phase métallique est entre 300 HV 0,005 et 600 HV 0,005.

6. Plaque pour impression en creux selon l'une quelconque des revendications précédentes, dans laquelle le pourcentage de la phase métallique est entre 15 et 70 % du côté substrat du revêtement et entre 0 et 15 % du côté opposé du revêtement.

7. Plaque pour impression en creux selon l'une quelconque des revendications précédentes, dans laquelle le pourcentage moyen de la phase métallique dans le matériau à gradient de fonctionnalité est entre 5 et 50 %.

8. Plaque pour impression en creux selon l'une quelconque des revendications précédentes, dans laquelle la variation du pourcentage de la phase métallique entre les deux côtés du revêtement est linéaire, parabolique, exponentielle, logarithmique ou une combinaison de ceux-ci.

9. Plaque pour impression en creux selon l'une quelconque des revendications précédentes, dans laquelle l'épaisseur totale du revêtement est entre 1,5 et 5 µm.

10. Plaque pour impression en creux selon l'une quelconque des revendications précédentes, dans laquelle le revêtement est déposé directement sur le substrat, ou sur une couche d'adhérence intermédiaire, de préférence une couche d'adhérence métallique.

11. Utilisation de la plaque pour impression en creux selon l'une quelconque des revendications précédentes dans un procédé d'impression en creux.
